# EUROPÄISCHE PATENTSCHRIFT

(11) **EP 3 931 579 B1**
(45) Veröffentlichungstag und Bekanntmachung des Hinweises auf die Patenterteilung: **04.09.2024**
(21) Anmeldenummer: 20707404.8
(22) Anmeldetag: 26.02.2020
(51) Int. Cl.: G01R 11/02, G01R 15/00, G01R 22/06

(54) **ADAPTER FÜR EIN ENERGIEMESSGERÄT UND VORRICHTUNG ZUR ENERGIEMESSUNG**
ADAPTER FOR AN ENERGY METER AND ENERGY MEASUREMENT DEVICE
ADAPTATEUR POUR APPAREIL DE MESURE D'ÉNERGIE ET DISPOSITIF POUR MESURE D'ÉNERGIE

(30) Priorität: 27.02.2019 DE 102019105017
(43) Veröffentlichungstag der Anmeldung: 05.01.2022
(73) Patentinhaber: PHOENIX CONTACT GMBH & CO. KG, 32825 Blomberg (DE)
(72) Erfinder: BERGMANN, Florian, 37603 Holzminden (DE); JANKOWSKI, Martin, 30926 Seelze (DE)
(74) Vertreter: Blumbach · Zinngrebe Patentanwälte PartG mbB
(86) Internationale Anmeldenummer: PCT/EP2020/055026
(87) Internationale Veröffentlichungsnummer: WO 2020/174004

(56) Entgegenhaltungen:
- WO-A1-2018/015202
- DE-U1- 202004 002 731
- US-A- 4 977 482
- US-B2- 8 837 101

## Beschreibung

Die Erfindung betrifft einen Adapter für ein Energiemessgerät und eine Vorrichtung zur Energiemessung und insbesondere zur Strom- und Spannungsmessung eines stromdurchflossenen Leiters.

Um in industriellen Einsatzgebieten Informationen über den Energieverbrauch zu erhalten, kann der benötigte Strom über das Magnetfeld eines stromdurchflossenen Leiters und die zwischen zwei Leitern liegende Spannung in einem Energiemessgerät gemessen werden.

Ein solches Energiemessgerät ist beispielsweise aus der DE 10 2018 106 940 A1 bekannt. Auch in der DE 10 2009 050 184 B4 ist eine Vorrichtung zum Messen eines elektrischen Energieverbrauchs beschrieben. Die bekannte Messvorrichtung weist ein Basisteil sowie ein mit diesem Basisteil verbindbares Prozessorteil auf, wobei zwischen dem Basisteil und dem Prozessorteil eine elektrische Verbindungeinrichtung vorgesehen ist. Die elektrischen Anschlüsse zum Anschließen der Messvorrichtung befinden sich allesamt am Basisteil.

Die bekannten Energiemessgeräte sind jeweils für eine vorbestimmte Spannungsfestigkeit ausgelegt, die Normen und Richtlinien einhalten muss. Mit Spannungsfestigkeit, auch als Durchschlagsfestigkeit bekannt, ist diejenige elektrische Feldstärke gemeint, welche in einem Material höchstens herrschen darf, ohne dass es zu einem Spannungsdurchschlag kommt. Das Verfahren zur Bestimmung der Durchschlagsfestigkeit ist in der Normenreihe IEC 60243 definiert. In den Energiemessgeräten müssen deshalb vorbestimmte Luftstrecken und Kriechstrecken zwischen elektrisch leitenden Komponenten eingehalten werden. Das bedeutet, dass mit den bekannten Energiemessgeräten aufgrund deren begrenzter Spannungsfestigkeit nur Spannungen bis zu einer definierten Spannungsobergrenze gemessen werden dürfen.

Aus der DE 10 2012 022 132 A1 ist ein Smartmeter bekannt, dessen Elektronik drei Schaltkreise aufweist, nämlich einen Primärschaltkreis, einen Sekundärschaltkreis und einen Messschaltkreis aufweist. Um einen geforderten Überspannungsschutz zu garantieren ist vorgesehen, dass der Messschaltkreis sowohl gegenüber dem Primärschaltkreis als auch gegenüber dem Sekundärschaltkreis eine Schutzisolierung mit einer Isolationsfestigkeit von jeweils mindestens 3 kV aufweist, wobei die Summe der Isolationsfestlichkeiten der beiden Schutzisolierungen wenigstens 8 kV beträgt und der Sekundärschaltkreis gegenüber dem Primärschaltkreis eine Schutzisolierung von 8 kV aufweist.

US 4 977 482 A offenbart einen Stromzähler-Steckdosenadapter mit elektrischen Kontakten, die die Anschlüsse eines Stromzählers aufnehmen, und Anschlüssen, die in die Kontakte einer elektrischen Stromzähler-Steckdose einsteckbar sind.

Der Erfindung liegt die Aufgabe zugrunde, einen Adapter und eine Vorrichtung zur Energiemessung bereitzustellen, die es ermöglichen, ein Energiemessgerät mit einer definierten Spannungsfestigkeit auch in Umgebungen einsetzen, die Messgeräte mit einer höheren Spannungsfestigkeit verlangen würde.

Das oben genannte technische Problem wird durch die Merkmale des Anspruchs 1 gelöst.

Demgemäß ist ein Adapter für ein Energiemessgerät vorgesehen, wobei der Adapter eine Spannungswandlereinrichtung, wenigstens zwei zweite elektrische Anschlüsse zum Anschließen an jeweils einen Leiters eines Stromnetzes und wenigstens zwei dritte elektrische Anschlüsse, an die ein Energiemessgerät elektrisch anschließbar ist, aufweist, wobei die Spannungswandlereinrichtung elektrisch mit den wenigstens zwei zweiten elektrischen und den wenigstens zwei dritten Anschlüssen elektrisch verbunden ist und eine an den wenigstens zwei zweiten elektrischen Anschlüssen anlegbare erste Spannung in eine niedrigere zweite Spannung umsetzt, die an den wenigstens zwei dritten elektrischen Anschlüssen anliegt, wobei das Spannungsverhältnis zwischen der ersten und zweiten Spannung vorbestimmt und in einem Energiemessgerät speicherbar ist, wobei zwischen den wenigstens zwei zweiten elektrischen Anschlüssen ein Abstand d1 besteht, der größer ist als der Abstand d2 zwischen den wenigstens zwei dritten elektrischen Anschlüssen.

Um eine kompakte und platzsparende Bauweise zu ermöglichen, kann in vorteilhafterweise der Adapter einen Aufnahmebereich aufweisen, der dazu ausgebildet ist, ein Energiemessgerät mit dem Adapter mechanisch lösbar zu verbinden.

Das oben genannte technische Problem wird ebenfalls durch die Merkmale des Anspruchs 3 gelöst.

Demnach ist eine Vorrichtung zur Energiemessung vorgesehen die ein Energiemessgerät und einen mit dem Energiemessgerät lösbar mechanisch verbindbaren Adapter aufweist. Das Energiemessgerät weißt wenigstens zwei erste elektrische Anschlüsse zum Anschließen an jeweils einen Leiter eines Stromnetzes, wenigstens ein erstes elektrisches Anschlusspaar zum Anschließen eines externen Stromsensors auf. Bei dem Energiemessgerät handelt es sich um ein Messgerät, welches insbesondere dazu ausgebildet ist, unmittelbar an ein Stromnetz angeschlossen werden zu können, um die in den stromführenden Leitern des Stromnetzes fließenden Ströme und die zwischen den Leitern des Stromnetzes liegenden Spannungen innerhalb zu messen. Der Adapter weist eine Spannungswandlereinrichtung, wenigstens zwei zweite elektrische Anschlüsse zum Anschließen an jeweils einen Leiter eines Stromnetzes und wenigstens zwei dritte elektrische Anschlüsse, die mit den wenigstens zwei ersten elektrischen Anschlüssen des Energiemessgerätes elektrisch verbindbar sind, auf. Die Spannungswandlereinrichtung ist elektrisch mit den wenigstens zwei zweiten elektrischen und den wenigstens zwei dritten Anschlüssen elektrisch verbunden. Sie ist ferner dazu ausgebildet, eine an den wenigstens zwei zweiten elektrischen Anschlüssen anlegbare erste Spannung in eine niedrigere zweite Spannung umzusetzen, die an den wenigstens zwei dritten elektrischen Anschlüssen anliegt. Das Spannungsverhältnis zwischen der ersten und zweiten Spannung ist vorbestimmt und in dem Energiemessgerät gespeichert. Zwischen den wenigstens zwei elektrischen Anschlüssen besteht ein Abstand d1, der größer ist als der Abstand d2 zwischen den wenigstens zwei dritten elektrischen Anschlüssen.

Dank des Adapters ist es möglich, die Spannungsfestigkeit der Vorrichtung zur Energiemessung gegenüber der Spannungsfestigkeit des eingesetzten Energiemessgeräts zu erhöhen. Dadurch wird auch ermöglicht, dass mit dem Energiemessgerät nunmehr Spannungen gemessen werden können, für die das Energiemessgerät aufgrund seiner vorbestimmten Spannungsfestigkeit nicht ausgelegt ist.

Vorteilhafte Weiterbildungen sind Gegenstand der Unteransprüche.

Um eine kompakte und platzsparende Bauweise der Vorrichtung zu ermöglichen, kann der Adapter einen Aufnahmebereich aufweisen, der dazu ausgebildet ist, das Energiemessgerät mit dem Adapter mechanisch lösbar zu verbinden, wobei im montierten Zustand, d. h. der Adapter und das Energiemessgerät sind mechanisch miteinander gekoppelt, die Baubreite und Bauhöhe der Vorrichtung zur Energiemessung durch die Breite und Bauhöhe des Adapters festgelegt. Dies wird insbesondere dadurch erreicht, dass dank des Aufnahmebereichs das Energiemessgerät auf dem Adapter lösbar befestigt werden kann.

Gemäß einer vorteilhaften Weiterbildung ist der Adapter in einem Gehäuse angeordnet, wobei der Aufnahmebereich durch das Profil des Gehäuses definiert ist. Im Aufnahmebereich kann eine Tragschiene angeordnet sein, wobei das Energiemessgerät zur Montage auf der Tragschiene des Adapters ausgebildet sein kann. Zudem kann das Gehäuse des Adapters zu Montage auf einer Tragschiene ausgebildet sein.

Dank dieser Ausgestaltung kann die Vorrichtung zur Energiemessung platzsparend zum Beispiel in einem Schaltschrank auf einer Tragschiene, beispielsweise einer Hutschiene aufgerastet werden.

Eine zweckmäßige Weiterbildung sieht vor, dass der Abstand zwischen den wenigstens zwei ersten elektrischen Anschlüssen des Energiemessgeräts dem Abstand d2 zwischen den wenigstens zwei dritten elektrischen Anschlüssen entspricht.

Eine zweckmäßige Weiterbildung sieht vor, dass das Energiemessgerät drei erste Anschlusspaare zum Anschließen jeweils eines Stromsensors und vier erste elektrische Anschlüsse aufweist, wobei jeweils zwei benachbarte Anschlüsse der vier ersten Anschlüsse den Abstand d2 aufweisen. Ferner kann der Adapter vier zweite elektrische Anschlüsse und vier dritte elektrische Anschlüsse aufweisen, wobei jeweils zwei benachbarte Anschlüsse der vier zweiten Anschlüsse den Abstand d1 und jeweils zwei benachbarte Anschlüsse der vier dritten Anschlüsse den Abstand d2 aufweisen.

Die Erfindung wird nachfolgend anhand eines Ausführungsbeispiels in Verbindung mit den beiliegenden Zeichnungen näher erläutert. Es zeigen:
- Figur 1: eine beispielhafte Anordnung einer erfindungsgemäßen Vorrichtung zur Energiemessung sowie ein herkömmliches Energiemessgerät, welche auf einer Tragschiene montiert sind,
- Figur 2: eine beispielhafte Anordnung einer erfindungsgemäßen Vorrichtung zur Energiemessung, wobei das Energiemessgerät und der Adapter seitlich nebeneinander auf einer Tragschiene montiert sind,
- Figur 3: eine schematische Draufsicht auf die in Figur 1 gezeigte Vorrichtung zur Energiemessung, welche an einem Stromnetz angeschlossen ist,
- Figur 4: den in Figur 1 gezeigten Adapter ohne aufgerastetes Energiemessgerät, und
- Figur 5: ein Blockschaltbild einer beispielhaften Spannungswandlereinrichtung, die im Adapter implementiert ist.

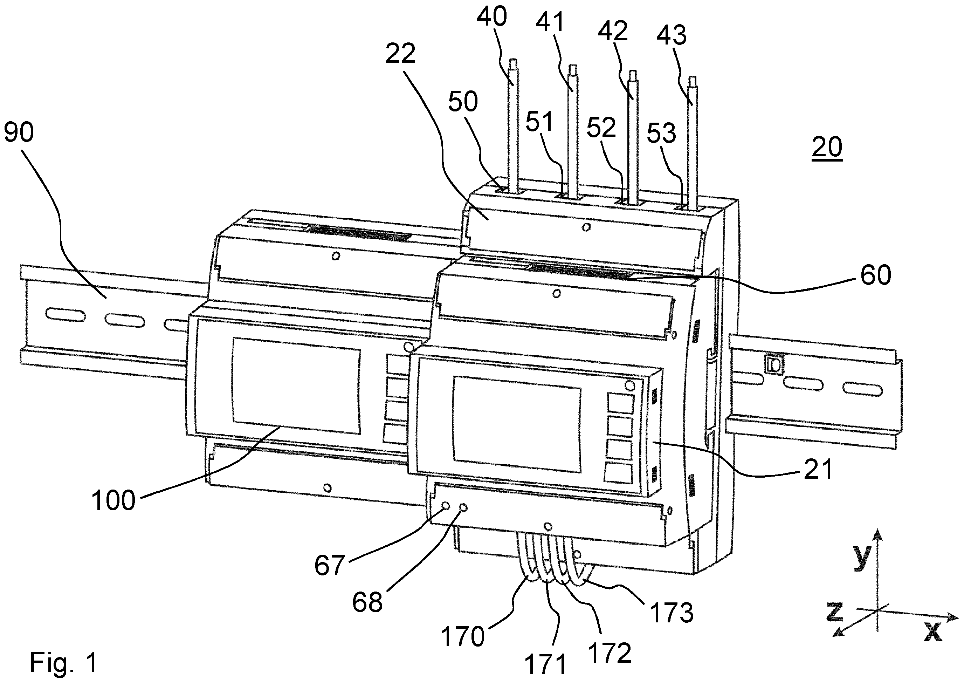

Figur 1 zeigt eine beispielhafte Installation zur Energiemessung in einer perspektivischen Darstellung, wobei ein Energiemessgerät 100 dargestellt ist, welches unmittelbar an einer Tragschiene 90 aufgerastet ist und an ein nicht dargestelltes Stromnetz angeschlossen werden kann. Weiterhin ist eine beispielhafte Vorrichtung zur Energiemessung 20 dargestellt, die ein Energiemessgerät 21 und einen Adapter 22 aufweist, wobei das Energiemessgerät 21 mechanisch und lösbar auf bzw. am Adapter 22 montiert ist. Der Adapter 22 kann ebenfalls an der Tragschiene 90 aufgerastet werden. Angemerkt sei, dass das Messgerät 21 baugleich und funktionsgleich zum Energiemessgerät 100 sein kann. Das heißt auch das Energiemessgerät 21 könnte direkt, d.h. ohne Adapter 22 an ein Stromnetz zur Strom- und Spannungsmessung angeschlossen werden.

Wie in Figur 1 ferner zu sehen ist, weist die Vorrichtung zur Energiemessvorrichtung 20 im montierten Zustand, d. h. das Energiemessgerät 21 ist mechanisch am Adapter 22 lösbar befestigt, eine Baubreite und eine Bauhöhe auf, die durch die Baubreite und die Bauhöhe des Adapters 22 festgelegt sind. Die Baubreite der Vorrichtung, des Adapters sowie des Energiemessgeräts 21 wird in x-Richtung des in Figur 1 gezeigten Koordinatensystems gemessen, während die Bauhöhe in y-Richtung des in Figur 1 gezeigten Koordinatensystems gemessen wird. Die Längsachse der in Figur 1 gezeigten Tragschiene 90 verläuft parallel zur x-Achse des in Figur 1 gezeigten Koordinatensystems. Auf diese Weise entsteht eine kompakte und platzsparende Baugruppe, die die Energiemessvorrichtung 20 bildet. Denn der Adapter 22 und das Energiemessgerät liegen bezüglich der z-Achse des in Figur 1 dargestellten Koordinatensystems über- bzw. hintereinander.

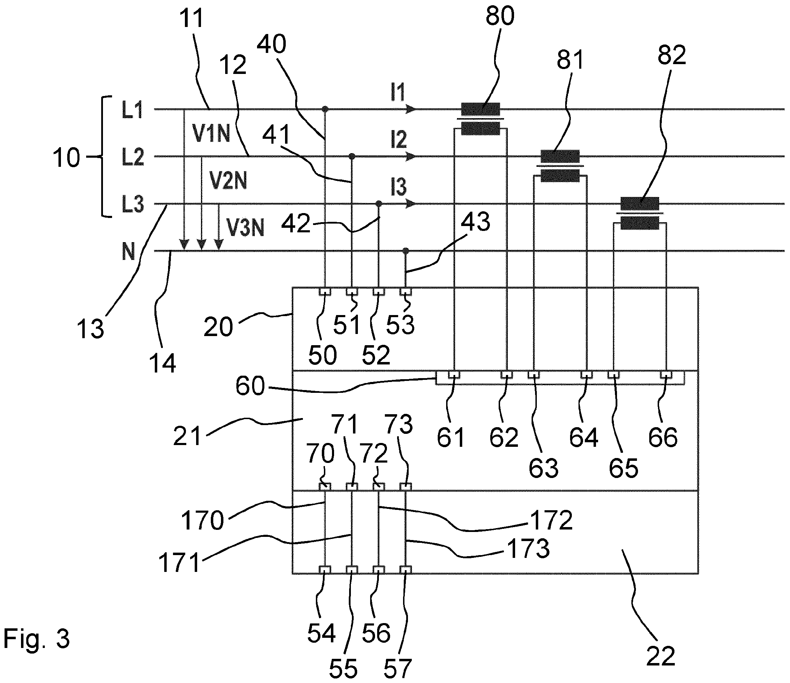

In Figur 1 sind beispielhaft vier elektrische Verbindungsleitungen 170 bis 173 gezeigt, die, wie in Figur 3 deutlicher zu sehen, im vorliegenden Beispiel vier elektrische Anschlüsse 54 bis 57 des Adapters 22 mit vier elektrischen Anschlüssen 70 bis 73 des Energiemessgeräts 21 verbinden.

Weiterhin sind in Figur 1 beispielhaft vier elektrische Anschlüsse 50 bis 53 des Adapters 22 dargestellt, die über vier Anschlussleitungen 40 bis 43 an drei Phasenleiter 11 bis 13 und einen Nullleiter 14 eines Stromnetzes 10, welches in Figur 3 dargestellt ist, angeschlossen werden können. Obwohl das in Figur 3 gezeigte Stromnetz 10 ein beispielhaftes dreiphasiges Niederspannungsnetz sein kann, kann das Stromnetz 10 durch jedes beliebige ein- oder mehrphasiges Stromnetz realisiert werden. Ferner weist das Energiemessgerät 21 in an sich bekannter Weise einen Anschlussbereich 60 auf, der wenigstens ein elektrisches Anschlusspaar zum Anschließen eines Stromsensors aufweist. Beispielhaft weist das Energiemessgerät 21 drei elektrische Anschlusspaare mit Anschlüssen 61 bis 66 auf, die jeweils mit einem Stromsensor 80,81 bzw. 82 verbunden werden können, wie dies in Figur 3 dargestellt ist.

Nunmehr wird Figur 3 näher betrachtet.

Das Energiemessgerät 21 weist wenigstens zwei erste elektrische Anschlüsse zum Anschließen an jeweils einen Leiter des Stromnetzes 10 auf. Da das beispielhafte Stromnetz 10 vier Leiter, nämlich die drei Phasenleiter 11 bis 13 und den Nullleiter 14 aufweist, verfügt das Energiemessgerät 21 im vorliegenden Beispiel über die vier erste Anschlüsse 70 bis 73, die bereits in Verbindung mit Figur 1 erwähnt worden sind. Bei der in Figur 3 gezeigten beispielhaften Installation ist der elektrische Anschluss 50 über die Verbindungsleitung 40 mit dem Phasenleiter 11 verbunden, der elektrische Anschluss 51 über die Verbindungsleitung 41 mit dem Phasenleiter 12 verbunden, der elektrische Anschluss 52 über die Verbindungsleitung 52 mit dem dritten Phasenleiter 13 und der Anschluss 53 über die Anschlussleitung 43 mit dem Nullleiter 14 des Stromnetzes 10 verbunden. Wie bereits weiter oben erwähnt, sind die vier ersten elektrischen Anschlüsse 70 bis 73 des Energiemessgeräts 21 nicht unmittelbar an die Leiter 11 bis 14 des Stromnetzes 10, sondern elektrisch über die Anschlussleitungen 170 bis 173 mit den dritten Anschlüsse 54 bis 57 des Adapters 22 verbunden. Das Energiemessgerät 21 weist in an sich bekannter Weise wenigstens ein erstes elektrisches Anschlusspaar zum Anschließen eines externen Stromsensors und vorzugsweise ein zweites elektrisches Anschlusspaar 67,68 zum Anschließen einer externen Versorgungsspannung für das Energiemessgerät 21 auf. Im gezeigten Ausführungsbeispiel sind drei erste elektrische Anschlusspaare vorgesehen, nämlich das erste Anschlusspaar mit den Anschlüssen 61 und 62, das zweite Anschlusspaar mit den Anschlüssen 63 und 64 und das dritte Anschlusspaar mit den Anschlüssen 65 und 66. Das erste elektrische Anschlusspaar ist mit einem Stromsensor 80 elektrisch verbunden, der in den ersten Phasenleiter 11 geschaltet ist, das zweite Anschlusspaar ist mit einem zweiten Stromsensor 81 verbunden, der in den zweiten Phasenleiter 12 geschaltet ist, während das dritte Anschlusspaar mit einem weiteren Stromsensor 82 elektrisch verbunden ist, der in den dritten Phasenleiter 13 eingeschleift ist. Wie in Figur 3 beispielhaft dargestellt, können die Stromsensoren 80 bis 82 jeweils als Stromwandler ausgebildet sein. Über die Stromsensoren 80 bis 82 wird der in den Phasenleitern 11 bis 13 fließende Strom dem Energiemessgerät direkt zugeführt.

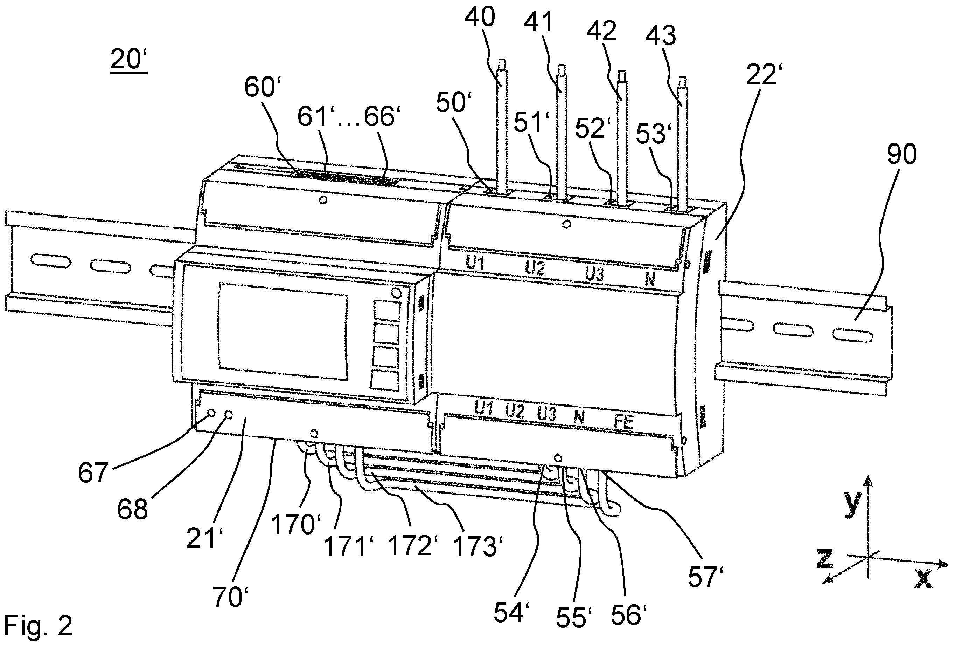

Der Adapter 22 weist wenigstens zwei zweite elektrische Anschlüsse zum Anschließen an jeweils einen Leiter eines Stromnetzes auf. Bei der beispielhaften Installation gemäß den Figuren 1 und 2 weist der Adapter 22 die vier zweiten elektrischen Anschlüsse 50 bis 53 auf. Der elektrische Anschluss 50 ist hierbei über die Anschlussleitung 40 mit dem ersten Phasenleiter 11 verbunden, der elektrische Anschluss 51 ist über die Anschlussleitung 41 mit dem zweiten Phasenleiter 12 verbunden, der elektrische Anschluss 52 ist über die Anschlussleitung 42 mit dem dritten Phasen Leiter 13 verbunden, während der Anschluss 53 über die Anschlussleitung 43 mit dem Nullleiter 14 des Stromnetzes 10 verbunden ist. Auf diese Weise wird die Spannung V1N, die zwischen dem ersten Phasenleiter 11 und dem Nullleiter 14 anliegt, eine zweite Spannung V2N, die zwischen dem zweiten Phasenleiter 12 und dem Nullleiter 14 anliegt, und die Spannung V3N, die zwischen dem dritten Phasenleiter 13 und den Nullleiter 14 anliegt an den Adapter 22 angelegt.

Der Adapter 22 weist weiter wenigstens zwei dritte elektrische Anschlüsse auf, die mit den wenigstens zwei ersten elektrischen Anschlüssen des Energiemessgeräts 21 elektrisch verbindbar sind. Bei dem gezeigten Ausführungsbeispiel weist der Adapter 22 die vier dritten elektrischen Anschlüsse 54 bis 57 auf. Der elektrische Anschluss 54 ist hierbei über die Anschlussleitung 170 mit dem Anschluss 70 des Energiemessgeräts 21 verbunden, der Anschluss 55 ist über die Anschlussleitung 171 mit dem Anschluss 71 des Energiemessgeräts verbunden, der elektrische Anschluss 56 ist über die Anschlussleitung 172 mit dem Anschluss 73 des Energiemessgeräts verbunden ist, während der Anschluss 57 über die Anschlussleitung 173 mit dem Anschluss 73 des Energiemessgeräts 21 verbunden ist.

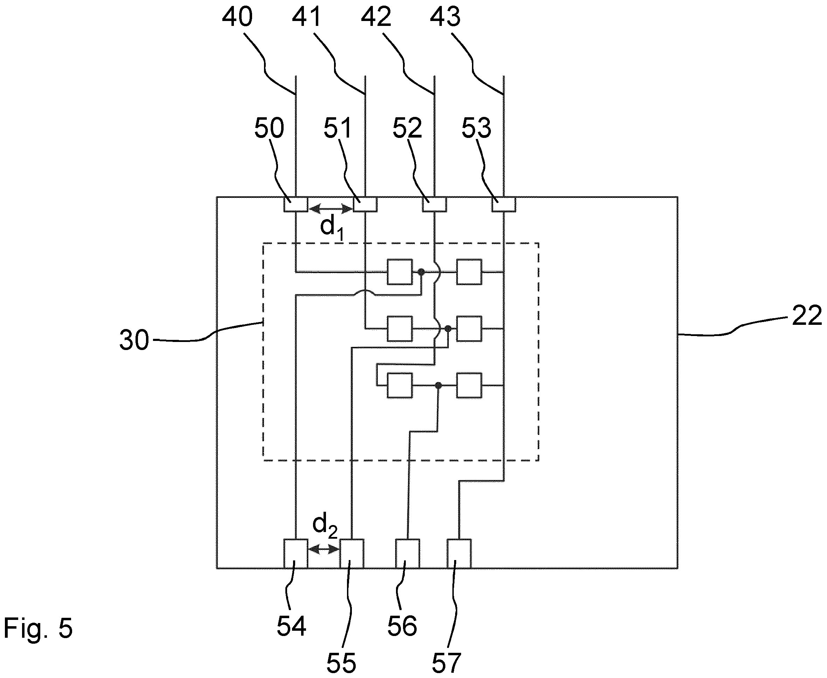

Weiterhin weist der Adapter 22 eine Spannungswandlereinrichtung 30 auf, die in Figur 5 zu sehen ist. Die Spannungswandlereinrichtung 30 ist mit den zweiten elektrischen Anschlüssen 50 bis 53 und den dritten Anschlüssen 54 bis 57 des Adapters 22 elektrisch verbunden. Die Spannungswandlereinrichtung 30 ist dazu ausgebildet, eine an den wenigstens zwei zweiten elektrischen Anschlüssen des Adapters 22 anlegbare erste Spannung in eine niedrigere zweite Spannung umzusetzen, die an den wenigstens zwei dritten elektrischen Anschlüssen des Adapters 22 anliegt.

Gemäß einer beispielhaften Ausgestaltung kann die Spannungswandlereinrichtung 30 drei Spannungsteiler aufweisen. Der erste Spannungsteiler weist beispielsweise zwei in Reihe geschaltete Widerstände 31 und 32 auf, die zwischen den Anschlüssen 50 und 53 angeschlossen sind. Die Mittelanzapfung des ersten Spannungsteilers ist elektrisch mit dem Anschluss 54 des Adapters 22 verbunden. Der zweite Spannungsteiler weist beispielsweise zwei in Reihe geschaltete Widerstände 33 und 34 auf. Der zweite Spannungsteiler ist zwischen die den Anschlüssen 51 und 53 angeschlossen. Die Mittelanzapfung des zweiten Spannungsteilers ist mit dem Anschluss 55 des Adapter 22 verbunden. Der Spannungsteiler weist beispielsweise zwei in Reihe geschaltete Widerstände 35 und 36 auf. Der dritte Spannungsteiler ist an die Anschlüsse 52 und 53 angeschlossen. Die Mittelanzapfung des dritten Spannungsteilers ist elektrisch mit dem Anschluss 56 verbunden. Die Anschlüsse 53 und 57 des Adapters 22 sind elektrisch miteinander verbunden. Auf diese Weise werden die Spannungen V1N, V2N und V3N des Stromnetzes 10 jeweils an die entsprechenden zweiten elektrischen Anschlüsse 50 bis 53 des Adapters 22 angelegt, über die jeweiligen Spannungsteiler der Spannungswandlereinrichtung 30 in eine niedrigere Spannung umgesetzt, wobei die herabgesetzte Spannung V1N an den Anschlüssen 54 und 57 anliegt, die herabgesetzte Spannung V2N an den Anschlüssen 55 und 57 anliegt, und die reduzierte Spannung V3N an den Anschlüssen 56 und 57 anliegt. Die reduzierten Spannungen werden dann über die Anschlüsse 54 bis 57 des Adapters 22 und die Anschlussleitungen 170 bis 173 an die entsprechenden Anschlüsse 70 bis 73 des Energiemessgeräts 21 angelegt. Die Spannungswandlereinrichtung 30 setzt die jeweiligen Spannungen gemäß einem definierten Spannungsverhältnis um, welches in dem Energiemessgerät 21 zur korrekten Spannungsmessung gespeichert ist. Zweckmäßigerweise setzen die drei Spannungswandler die Spannungen mit demselben Spannungsverhältnis um. Angemerkt sei an dieser Stelle, dass anstelle der drei Spannungsteiler die Spannungswandlereinrichtung 30 beispielsweise auch drei Transformatoren mit definierten Übersetzungsverhältnissen enthalten kann.

Um die Spannungsfestigkeit der Energiemessvorrichtung 20 gegenüber der Spannungsfestigkeit des Energiemessgeräts 21 erhöhen zu können, besteht jeweils zwischen zwei benachbarten elektrischen Anschlüssen der zweiten elektrischen Anschlüsse 50 bis 53 ein vorbestimmter Abstand d1, der größer ist als der Abstand d2 zwischen benachbarten Anschlüssen der dritten elektrischen Anschlüsse 54 bis 57. Vorzugsweise ist der Abstand zwischen benachbarten Anschlüssen der ersten elektrischen Anschlüsse 70 bis 73 des Energiemessgeräts 21 gleich dem Abstand d2 zwischen benachbarten Anschlüssen der dritten elektrischen Anschlüsse 54 bis 57 des Adapter 22. Dank der Energiemessvorrichtung 10 werden somit die zwischen den jeweiligen Phasenleitern und dem Nullleiter des Stromnetzes 10 anliegenden Spannungen über den Adapter 22 reduziert an die Anschlüsse 70 bis 73 des Energiemessgeräts 21 angelegt, während die jeweils in den Phasenleitern 11 bis 13 fließenden elektrischen Ströme über die jeweiligen Stromsensoren 80 bis 82 direkt über die Anschlüsse 61 bis 66 der drei Anschlusspaare in das Energiemessgerät 21 eingespeist werden. Das Energiemessgerät 21 ist dazu ausgebildet, in an sich bekannter Weise die Ströme und Spannungen des Stromnetzes 10 zu messen und daraus einen Energieverbrauch zu ermitteln.

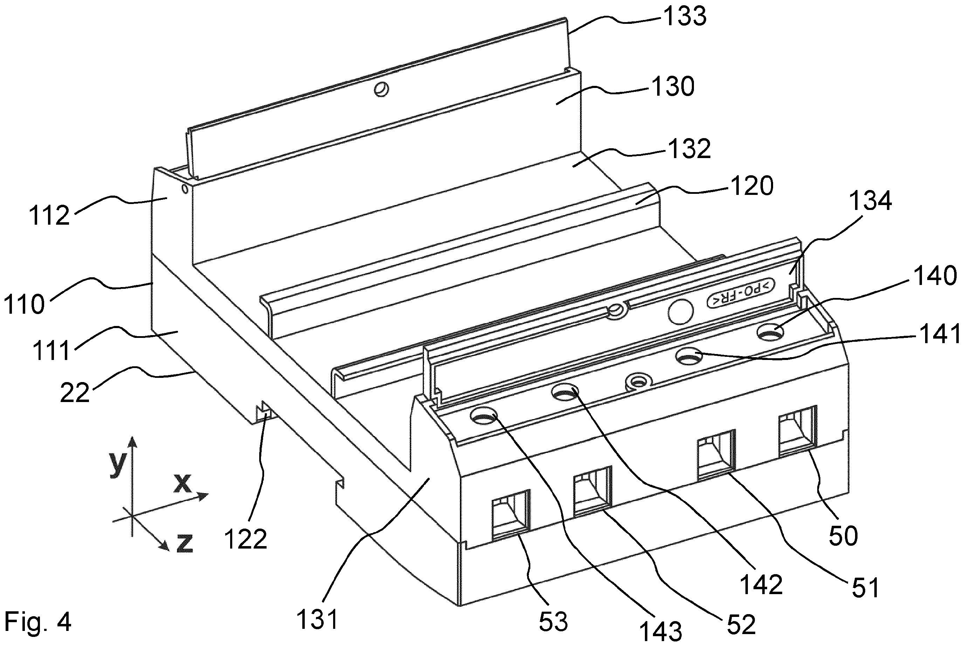

In Figur 4 ist der beispielhafte Adapter 22 ohne Energiemessgerät 21 detaillierter dargestellt. Der Adapter 22 weist ein Gehäuse 110 auf, einteilig oder mehrteilig realisiert sein kann. Wie beispielhaft dargestellt, weist das Gehäuse 110 beispielsweise ein Basisteil 111 auf, welches im Wesentlichen die Form eines Quaders aufweist, wobei die Unterseite eine Aussparung 122 aufweisen kann, die derart ausgebildet ist, dass der Adapter 22 auf der in Figur 1 gezeigten Hutschiene 90 aufgerastet werden kann. In dem Basisteil 111 des Gehäuses 110 kann die in Figur 5 gezeigte Spannungswandlereinrichtung 30 angeordnet sein. Auf der Oberseite des Basisteils 111 kann ein profiliertes Oberteil 112 angeordnet sein, welches eine ebene Grundfläche 132 besitzt, die in der x-z-Ebene des in der Figur 4 gezeigten Koordinatensystems liegt. An zwei gegenüberliegenden, in x-Richtung verlaufende Seiten des Oberteils 112 erstrecken sich von der Grundfläche 132 zwei Seitenwände 130 und 131 senkrecht in y-Richtung. Die Grundfläche 132 bildet zusammen mit den beiden Seitenwänden 130 und 131 einen Aufnahmebereich zur Aufnahme des Energiemessgerätes 21. An der ebenen Grundfläche 132 des Oberteils 112 kann eine in x-Richtung, also parallel zu den Seitenwänden 130 und 131 verlaufende Tragschiene 120 angeordnet sein. Auf die Tragschiene 120 des Adapters 22 kann das Energiemessgerät 21 aufgerastet werden. In der Seitenwand 131 können Öffnungen vorgesehen sein, die in z-Richtung weisen und in denen jeweils die elektrischen Anschlüsse 50 bis 53 des Adapters 22 angeordnet sind. Um eine sichere Kontaktierung zwischen den Anschlussleitungen 40 bis 43 und den Anschlüsse 50 bis 53 herstellen zu können, können Öffnungen 140-143 in der Seitenwand 131 vorgesehen sein, in jeweils eine Schraube eingeführt werden kann, um die Anschlussleitungen 40 bis 43 an die Anschlüsse 50 bis 53 anschließen zu können. In ähnlicher Weise können in der Seitenwand 130 Öffnungen vorgesehen sein, die in -z-Richtung weisen und in denen jeweils die elektrischen Anschlüsse 54 bis 57 des Adapters 22 angeordnet sind. Um eine sichere Kontaktierung zwischen den Anschlussleitungen 170 bis 173 und den Anschlüsse 54 bis 57 herstellen zu können, können Öffnungen in der Seitenwand 130 vorgesehen sein, in jeweils eine Schraube eingeführt werden kann, um die Anschlussleitungen 170 bis 173 an die Anschlüsse 54 bis 57 anschließen zu können. Aufgrund der perspektivischen Darstellung sind jedoch die Öffnungen in der Seitenwand 130 nicht zu sehen.

In vorteilhafter Weise sind die Öffnungen 140 bis 143 in der Seitenwand 131 und die entsprechenden Öffnungen in der Seitenwand 130 mittels einer Klappe 134 bzw. 133 beispielsweise gegen Verschmutzung geschützt.

Angemerkt sei, dass die Auflagefläche des Aufnahmebereichs des Adapters 22, der durch die Grundfläche 132 und die beiden Seitenwände 130 und 131 des Gehäuses 110 definiert wird, vorteilhafterweise der Querschnittsfläche des Energiemessgeräts 21, die durch die x- und y-Achse des in Fig. 1 gezeigten Koordinatensystems aufgespannt wird, entspricht. Auf diese Weise wird erreicht, dass die parallel zur y-Achse des in Figur 1 gezeigten Koordinatensystems verlaufende Bauhöhe der Energiemessvorrichtung 10 und die parallel zur x-Achse des in Figur 1 gezeigten Koordinatensystems verlaufende Baubreite der Energiemessvorrichtung 10 der Bauhöhe und Baubreite des Adapters 22 entsprechen.

In Fig. 2 ist eine alternative Energiemessvorrichtung 20' mit einem Energiemessgerät 21' und einem Adapter 22' gezeigt, die sich im Wesentlichen dadurch von der in Figur 1 Energiemessvorrichtung 20 unterscheidet, dass der Adapter 22' keinen Aufnahmebereich aufweist und deshalb das Energiemessgerät 21' und der Adapter 22' seitlich nebeneinander an der Tragschiene 90 aufgerastet sind. Im Übrigen können das Energiemessgerät 21' identisch zum Energiemessgerät 21 und der Adapter 22' identisch zum Adapter 22 implementiert sein. Mit anderen Worten: Die in Figur 5 beispielhaft gezeigte Spannungswandlereinrichtung 30 kann unverändert im Adapter 22' implementiert werden. Zudem können das Energiemessgerät 21' und der Adapter 22' ähnlich dem Energiemessgerät 21 und dem Adapter 22 an das in Figur 3 gezeigte Stromnetz 10 angeschlossen werden.

Das Energiemessgerät 21` weist wenigstens zwei erste elektrische Anschlüsse zum Anschließen an jeweils einen Leiter des Stromnetzes 10 auf. Da das beispielhafte Stromnetz 10 vier Leiter, nämlich die drei Phasenleiter 11 bis 13 und den Nullleiter 14 aufweist, verfügt das Energiemessgerät 21' im vorliegenden Beispiel über die vier erste Anschlüsse 70` bis 73`, die bereits in Verbindung mit Figur 1 erwähnt worden sind. Der elektrische Anschluss 50' kann über die Verbindungsleitung 40 mit dem Phasenleiter 11 verbunden, der elektrische Anschluss 51` über die Verbindungsleitung 41 mit dem Phasenleiter 12 verbunden, der elektrische Anschluss 52` über die Verbindungsleitung 52 mit dem dritten Phasenleiter 13 und der Anschluss 53` über die Anschlussleitung 43 mit dem Nullleiter 14 des Stromnetzes 10 verbunden werden. Die vier ersten elektrischen Anschlüsse 70` bis 73' des Energiemessgeräts 21' werden nicht unmittelbar an die Leiter 11 bis 14 des Stromnetzes 10, sondern elektrisch über die Anschlussleitungen 170' bis 173` mit den dritten Anschlüsse 54' bis 57' des Adapters 22' verbunden. Das Energiemessgerät 21' weist in an sich bekannter Weise wenigstens ein erstes elektrisches Anschlusspaar zum Anschließen eines externen Stromsensors und vorzugsweise ein zweites elektrisches Anschlusspaar 67', 68` zum Anschließen einer externen Versorgungsspannung für das Energiemessgerät 21' auf. Im gezeigten Ausführungsbeispiel sind drei erste elektrische Anschlusspaare vorgesehen, nämlich das erste Anschlusspaar mit den Anschlüssen 61' und 62`, das zweite Anschlusspaar mit den Anschlüssen 63' und 64` und das dritte Anschlusspaar mit den Anschlüssen 65' und 66`. Das erste elektrische Anschlusspaar kann mit einem Stromsensor 80 elektrisch verbunden werden, der in den ersten Phasenleiter 11 geschaltet ist, das zweite Anschlusspaar kann mit einem zweiten Stromsensor 81 verbunden werden, der in den zweiten Phasenleiter 12 geschaltet ist, während das dritte Anschlusspaar mit einem weiteren Stromsensor 82 elektrisch verbunden werden kann, der in den dritten Phasenleiter 13 eingeschleift ist. Wie in Figur 3 beispielhaft dargestellt, können die Stromsensoren 80 bis 82 jeweils als Stromwandler ausgebildet sein. Über die Stromsensoren 80 bis 82 wird der in den Phasenleitern 11 bis 13 fließende Strom dem Energiemessgerät 21` direkt zugeführt.

Der Adapter 22` weist wenigstens zwei zweite elektrische Anschlüsse zum Anschließen an jeweils einen Leiter eines Stromnetzes auf. Bei der beispielhaften Installation gemäß der Figur 2 weist der Adapter 22' die vier zweiten elektrischen Anschlüsse 50' bis 53' auf. Der elektrische Anschluss 50' kann hierbei über die Anschlussleitung 40 mit dem ersten Phasenleiter 11 verbunden werden, der elektrische Anschluss 51' kann über die Anschlussleitung 41 mit dem zweiten Phasenleiter 12 verbunden, der elektrische Anschluss 52` kann über die Anschlussleitung 42 mit dem dritten Phasen Leiter 13 verbunden, während der Anschluss 53` über die Anschlussleitung 43 mit dem Nullleiter 14 des Stromnetzes 10 verbunden werden kann. Auf diese Weise wird die Spannung V1N, die zwischen dem ersten Phasenleiter 11 und dem Nullleiter 14 anliegt, eine zweite Spannung V2N, die zwischen dem zweiten Phasenleiter 12 und dem Nullleiter 14 anliegt, und die Spannung V3N, die zwischen dem dritten Phasenleiter 13 und den Nullleiter 14 anliegt an den Adapter 22' angelegt.

Der Adapter 22` weist weiter wenigstens zwei dritte elektrische Anschlüsse auf, die mit den wenigstens zwei ersten elektrischen Anschlüssen des Energiemessgeräts 21' elektrisch verbindbar sind. Bei dem gezeigten Ausführungsbeispiel weist der Adapter 22' die vier dritten elektrischen Anschlüsse 54' bis 57' auf. Der elektrische Anschluss 54' ist hierbei über die Anschlussleitung 170` mit dem Anschluss 70' des Energiemessgeräts 21' verbunden, der Anschluss 55' ist über die Anschlussleitung 171` mit dem Anschluss 71' des Energiemessgeräts 21' verbunden, der elektrische Anschluss 56' ist über die Anschlussleitung 172' mit dem Anschluss 73` des Energiemessgeräts 21' verbunden ist, während der Anschluss 57' über die Anschlussleitung 173` mit dem Anschluss 73` des Energiemessgeräts 21' verbunden ist.

## Patentansprüche

1. Adapter (22, 22') für ein Energiemessgerät, wobei der Adapter (22, 22' eine Spannungswandlereinrichtung (30), wenigstens zwei zweite elektrische Anschlüsse (50-53; 50`-53`) zum Anschließen an jeweils einen Leiters (11-14) eines Stromnetzes (10) und wenigstens zwei dritte elektrische Anschlüsse (54-57; 54`-57`), an die ein Energiemessgerät (21; 21`) elektrisch anschließbar ist, aufweist, wobei die Spannungswandlereinrichtung (30) elektrisch mit den wenigstens zwei zweiten elektrischen (50-53) und den wenigstens zwei dritten Anschlüssen (54-57) elektrisch verbunden ist und eine an den wenigstens zwei zweiten elektrischen Anschlüssen (50-53) anlegbare erste Spannung in eine niedrigere zweite Spannung umsetzt, die an den wenigstens zwei dritten elektrischen Anschlüssen (54-57) anliegt, wobei das Spannungsverhältnis zwischen der ersten und zweiten Spannung vorbestimmt und in einem Energiemessgerät (21, 21`) speicherbar ist, wobei zwischen den wenigstens zwei zweiten elektrischen Anschlüssen (50-53; 50`-53`) ein Abstand d1 besteht, der größer ist als der Abstand d2 zwischen den wenigstens zwei dritten elektrischen Anschlüssen (54-57; 54`-57`).

2. Adapter (22) nach Anspruch 1,
**dadurch gekennzeichnet, dass**,
der Adapter (22) einen Aufnahmebereich (130-132) aufweist, der dazu ausgebildet ist, ein Energiemessgerät (21) mit dem Adapter (22) mechanisch lösbar zu verbinden.

3. Vorrichtung (20, 20') zur Energiemessung aufweisend
- ein Energiemessgerät (21, 21'), welches wenigstens zwei erste elektrische Anschlüsse (70-73; 70`-73`) zum Anschließen an jeweils einen Leiter eines Stromnetzes, wenigstens ein erstes elektrisches Anschlusspaar (61-66; 61`-66`) zum Anschließen eines externen Stromsensors (80-82), und
- einen Adapter gemäß einem der Ansprüche 1 oder 2.

4. Vorrichtung nach Anspruch 3,
**dadurch gekennzeichnet, dass**
der Adapter (22) einen Aufnahmebereich (130-132) aufweist, der dazu ausgebildet ist, das Energiemessgerät (21) mit dem Adapter (22) mechanisch lösbar zu verbinden, wobei im montierten Zustand die Baubreite und Bauhöhe der Vorrichtung (20) durch die Baubreite und Bauhöhe des Adapters (22) festgelegt sind.

5. Vorrichtung nach Anspruch 4,
**dadurch gekennzeichnet, dass**
der Adapter (22) in einem Gehäuse (110) angeordnet ist, der Aufnahmebereich (130-132) durch das Gehäuse definiert ist, im Aufnahmebereich eine Tragschiene (120) angeordnet ist, das Energiemessgerät (21) zur Montage auf der Tragschiene (120) des Adapters (22) ausgebildet ist, und dass
Gehäuse (110) des Adapters (22) zur Montage auf einer Tragschiene ausgebildet ist.

6. Vorrichtung nach einem der Ansprüche 3 bis 5,
**dadurch gekennzeichnet, dass**
der Abstand zwischen den wenigstens zwei ersten elektrischen Anschlüssen (70-73; 70`-73`) des Energiemessgeräts (21, 21`) dem Abstand d2 zwischen den wenigstens zwei dritten elektrischen Anschlüssen (54-57; 54'-57') entspricht.

7. Vorrichtung nach einem der Ansprüche 3 bis 6,
**dadurch gekennzeichnet, dass**
das Energiemessgerät (21, 21`) drei erste Anschlusspaare (61-66; 61`-66`) zum Anschließen jeweils eines Stromsensors (80-82) und vier erste elektrische Anschlüsse (70-73; 70`-73`) aufweist, wobei jeweils zwei benachbarte Anschlüsse der vier ersten Anschlüsse (70-73; 70`-73`) den Abstand d2 aufweisen, und dass
der Adapter (22; 22') vier zweite elektrische Anschlüsse (50-53; 50`-53`) und vier dritte elektrische Anschlüsse (54-57; 54`-57`) aufweist, wobei jeweils zwei benachbarte Anschlüsse der vier zweiten Anschlüsse (50-53; 50`-53`)den Abstand d1 und jeweils zwei benachbarte Anschlüsse der vier dritten Anschlüsse (54-57; 54`-57`) den Abstand d2 aufweisen.

8. Vorrichtung nach einem der Ansprüche 3 bis 7,
**dadurch gekennzeichnet, dass**
das Energiemessgerät (21, 21`) ein zweites elektrisches Anschlusspaar (67, 68; 67', 68') zum Anschließen einer Versorgungsspannung für das Energiemessgerät aufweist.

## Claims

1. An adapter (22, 22') for an energy meter, wherein the adapter (22, 22') has a voltage converter (30), at least two second electrical terminals (50-53; 50'-53') for connecting to respective conductors (11-14) of a power network (10) and at least two third electrical terminals (54-57; 54'-57') to which an energy meter (21; 21') can be electrically connected, wherein the voltage converter (30) is electrically connected to the at least two second electrical terminals (50-53) and the at least two third terminals (54-57) and converts a first voltage which can be applied to the at least two second electrical terminals (50-53) to a lower second voltage that is applied to the at least two third electrical terminals (54-57), wherein the voltage ratio between the first and the second voltage is predetermined and can be stored in an energy meter (21, 21'), wherein there is a distance d1 between the at least two second electrical terminals (50-53; 50'-53') that is greater than the distance d2 between the at least two third electrical terminals (54-57; 54'-57').

2. The adapter (22) according to claim 1, **characterized in that**
the adapter (22) has a receiving region (130-132) which is designed to connect an energy meter (21) to the adapter (22) in a mechanically detachable manner.

3. An energy measurement device (20, 20') having
- an energy meter (21, 21'), which has at least two first electrical terminals (70-73; 70'-73') for connecting to respective conductors of a power network, at least one first electrical terminal pair (61-66; 61'-66') for connecting an external current sensor (80-82), and
- an adapter according to one of claims 1 or 2.

4. The device according to claim 3, **characterized in that**
the adapter (22) has a receiving region (130-132) which is designed to connect the energy meter (21) to the adapter (22) in a mechanically detachable manner, wherein the overall width and overall height of the device (20) are determined by the overall width and overall height of the adapter (22) in the assembled state.

5. The device according to claim 4, **characterized in that**
the adapter (22) is arranged in a housing (110), the receiving region (130-132) is defined by the housing, a mounting rail (120) is arranged in the receiving region, the energy meter (21) is designed for mounting on the mounting rail (120) of the adapter (22), and the housing (110) of the adapter (22) is designed for mounting on the mounting rail.

6. The device according to any one of claims 3 to 5, **characterized in that**
the distance between the at least two first electrical terminals (70-73; 70'-73') of the energy meter (21, 21') is equal to the distance d2 between the at least two third electrical terminals (54-57; 54'-57').

7. The device according to any one of claims 3 to 6, **characterized in that**
the energy meter (21, 21') has three first terminal pairs (61-66; 61'-66') for respectively connecting one current sensor (80-82) and four first electrical terminals (70-73; 70'-73'), wherein every two adjacent terminals of the four first terminals (70-73; 70'-73') are spaced apart by the distance d2, and **in that**
the adapter (22; 22') has four second electrical terminals (50-53; 50'-53') and four third electrical terminals (54-57; 54'-57'), wherein every two adjacent terminals of the four second terminals (50-53; 50'-53') are spaced apart by the distance d1 and every two adjacent terminals of the four third terminals (54-57; 54'-57') are spaced apart by the distance d2.

8. The device according to any one of claims 3 to 7, **characterized in that**
the energy meter (21, 21') has a second electrical terminal pair (67, 68; 67', 68') for connecting a supply voltage for the energy meter.

## Revendications

1. Adaptateur (22, 22') pour un appareil de mesure d'énergie, dans lequel l'adaptateur (22, 22') présente un dispositif de conversion de tension (30), au moins deux deuxièmes raccordements (50-53 ; 50'-53') électriques destinés à être raccordés à respectivement un conducteur (11-14) d'un réseau électrique (10) et au moins deux troisièmes raccordements (54-57 ; 54'-57') électriques, auxquels un appareil de mesure d'énergie (21 ; 21') peut être raccordé électriquement, dans lequel le dispositif de conversion de tension (30) est raccordé électriquement aux au moins deux deuxièmes raccordements (50-53) électriques et aux au moins deux troisièmes raccordements (54-57) et transforme une première tension pouvant être appliquée sur les au moins deux deuxièmes raccordements (50-53) électriques en une deuxième tension plus basse, qui est appliquée sur les au moins deux troisièmes raccordements (54-57) électriques, dans lequel le rapport de tension entre la première tension et la deuxième tension est prédéfini et peut être mémorisé dans un appareil de mesure d'énergie (21, 21'), dans lequel il existe, entre les au moins deux deuxièmes raccordements (50-53 ; 50'-53') électriques, une distance d1 qui est plus grande que la distance d2 entre les au moins deux troisièmes raccordements (54-57 ; 54'-57') électriques.

2. Adaptateur (22) selon la revendication 1,
**caractérisé en ce que**
l'adaptateur (22) présente une zone de logement (130-132), qui est réalisée pour raccorder de manière amovible mécaniquement un appareil de mesure d'énergie (21) à l'adaptateur (22).

3. Dispositif (20, 20') de mesure d'énergie, présentant
- un appareil de mesure d'énergie (21, 21'), lequel présente au moins deux premiers raccordements (70-73 ; 70'-73') électriques destinés à être raccordés à respectivement un conducteur d'un réseau électrique, au moins une première paire de raccordements (61-66 ; 61'-66') électriques pour le raccordement d'un capteur de courant (80-82) externe, et
- un adaptateur selon l'une quelconque des revendications 1 ou 2.

4. Dispositif selon la revendication 3,
**caractérisé en ce que**
l'adaptateur (22) présente une zone de logement (130-132), qui est réalisée pour raccorder de manière amovible mécaniquement l'appareil de mesure d'énergie (21) à l'adaptateur (22), dans lequel dans l'état monté, la largeur de construction et la hauteur de construction du dispositif (20) sont fixées par la largeur de construction et la hauteur de construction de l'adaptateur (22).

5. Dispositif selon la revendication 4,
**caractérisé en ce que**
l'adaptateur (22) est disposé dans un boîtier (110), la zone de logement (130-132) est définie par le boîtier, un rail de support (120) est disposé dans la zone de logement, l'appareil de mesure d'énergie (21) est réalisé pour être monté sur le rail de support (120) de l'adaptateur (22), et que
le boîtier (110) de l'adaptateur (22) est réalisé pour être monté sur un rail de support.

6. Dispositif selon l'une quelconque des revendications 3 à 5,
**caractérisé en ce que**
la distance entre les au moins deux premiers raccordements (70-73 ; 70'-73') électriques de l'appareil de mesure d'énergie (21, 21') correspond à la distance d2 entre les au moins deux troisièmes raccordements (54-57 ; 54'-57') électriques.

7. Dispositif selon l'une quelconque des revendications 3 à 6,
**caractérisé en ce que**
l'appareil de mesure d'énergie (21, 21') présente trois premières paires de raccordements (61-66 ; 61'-66') pour le raccordement respectivement d'un capteur de courant (80-82) et quatre premiers raccordements (70-73 ; 70'-73') électriques, dans lequel respectivement deux raccordements adjacents des quatre premiers raccordements (70-73 ; 70'-73') présentent la distance d2, et que
l'adaptateur (22 ; 22') présente quatre deuxièmes raccordements (50-53 ; 50'-53') électriques et quatre troisièmes raccordements (54-57 ; 54'-57') électriques,
dans lequel respectivement deux raccordements adjacents des quatre deuxièmes raccordements (50-53 ; 50'-53') présentent la distance d1 et respectivement deux raccordements adjacents des quatre troisièmes raccordements (54-57 ; 54'-57') présentent la distance d2.

8. Dispositif selon l'une quelconque des revendications 3 à 7,
**caractérisé en ce que**
l'appareil de mesure d'énergie (21, 21') présente une deuxième paire de raccordements (67, 68 ; 67', 68') électriques pour le raccordement d'une tension d'alimentation pour l'appareil de mesure d'énergie.
